# EUROPÄISCHE PATENTANMELDUNG

(11) **EP 2 631 946 A1**
(43) Veröffentlichungstag der Anmeldung: **28.08.2013**
(21) Anmeldenummer: 13150224.7
(22) Anmeldetag: 04.01.2013
(51) Int. Cl.: H01L 25/16, H01L 23/538, H01L 25/07, H01L 25/18

(54) **Leistungshalbleitermodul**

(30) Priorität: 23.02.2012 DE 102012202765
(71) Anmelder: SEMIKRON Elektronik GmbH & Co. KG, 90431 Nürnberg (DE)
(72) Erfinder: Bittner, Roland, 96135 Stegaurach (DE); Kalkmann, Bernhard, 91126 Schwabach (DE); Maul, Andreas, 90461 Nürnberg (DE)

(57) **Zusammenfassung**

Die Anmeldung betrifft ein Halbleitermodul mit einem Substrat (12) und einem Kondensator (2), wobei das Substrat einen Isolierstoffkörper (14) und eine auf dem Isolierstoffkörper angeordnete elektrisch leitende strukturierte Leitungsschicht (15) aufweist, wobei auf der strukturierten Leitungsschicht ein erster und ein zweiter Halbleiterschalter (T1,T2) und eine erste und eine zweite Diode (D1,D2) angeordnet sind und mit der strukturierten Leitungsschicht verbunden sind, wobei das Halbleitermodul einen Folienverbund (16), der eine erste und eine zweite metallische Folienschicht (17,19) sowie eine zwischen der ersten und der zweiten metallischen Folienschicht angeordnete elektrisch isolierende Folienschicht (18) aufweist, wobei mindestens eine der metallischen Folienschichten strukturiert ist, wobei der erste Halbleiterschalter und die zweite Diode mit dem Folienverbund verbunden sind, wobei ein erster elektrischer Anschluss (26) des Kondensators mit dem Folienverbund verbunden ist und ein zweiter elektrischer Anschluss (23) des Kondensators mit der strukturierten Leitungsschicht des Substrats elektrisch leitend verbunden ist. Die Erfindung schafft ein Halbleitermodul mit mindestens einem Kondensator und mindestens einer Brückenschaltung, das einen besonders niederinduktiven Aufbau aufweist.

## Beschreibung

Die Erfindung betrifft ein Halbleitermodul.

Bei aus dem Stand der Technik bekannten Halbleitermodulen sind auf einem Substrat Halbleiterschalter und Dioden angeordnet und mittels einer Leiterschicht des Substrats, Bonddrähte und/oder einer Folienschicht miteinander elektrisch leitend verbunden. Die Halbleiterschalter liegen dabei üblicherweise in Form von Transistoren wie z.B. IGBTs oder MOSFETs vor. Die auf dem Substrat angeordneten Halbleiterschalter und die Dioden sind dabei häufig elektrisch zu einer einzelnen oder mehreren sogenannten Halbbrückenschaltungen verschalten, die üblicherweise zum Gleich- und Wechselrichten von elektrischen Spannungen und Strömen verwendet werden.

Aus der DE 103 55 925 A1 ist ein Leistungshalbleitermodul bekannt, bei dem Halbleiterbauelemente mittels eines Folienverbundes elektrisch miteinander verbunden werden.

Aus der DE 10 2009 001 919 A1 sind Halbleiterkondensatoren bekannt.

Die elektrischen Verbindungen zwischen den Dioden, Halbleiterschaltern und gegebenenfalls weiteren Elementen weisen parasitäre Induktivitäten auf, die beim Ausschalten der Halbleiterschalter zu Überspannungen führen. Um die Überspannungen zu reduzieren, sind die Halbbrückenschaltung oder die Halbbrückenschaltungen mit einem Kondensator elektrisch leitend verbunden, der fachspezifisch auch als sogenannter Snubberkondensator bezeichnet wird. Zur Minimierung der Überspannungen ist weiterhin ein besonders niederinduktiver Aufbau der Halbbrückenschaltung oder der Halbbrückenschaltungen sowie eine besonders niederinduktive elektrische Anbindung des Kondensators an die Halbbrückenschaltung oder an die Halbbrückenschaltungen wünschenswert.

Es ist Aufgabe der Erfindung ein Halbleitermodul mit mindestens einem Kondensator und mindestens einer Brückenschaltung zu schaffen, das einen besonders niederinduktiven Aufbau aufweist.

Diese Aufgabe wir gelöst durch ein Halbleitermodul mit einem Substrat und einem Kondensator, wobei das Substrat einen Isolierstoffkörper und eine auf dem Isolierstoffkörper angeordnete elektrisch leitende strukturierte Leitungsschicht aufweist, wobei auf der strukturierten Leitungsschicht ein erster und ein zweiter Halbleiterschalter und eine erste und eine zweite Diode angeordnet sind und mit der strukturierten Leitungsschicht verbunden sind, wobei das Halbleitermodul einen Folienverbund, der eine erste und eine zweite metallische Folienschicht sowie eine zwischen der ersten und eine zweiten metallischen Folienschicht angeordnete elektrisch isolierende Folienschicht aufweist, wobei mindestens eine der metallischen Folienschichten strukturiert ist, wobei der erste Halbleiterschalter und die zweite Diode mit dem Folienverbund verbunden sind, wobei ein erster elektrischer Anschluss eines Kondensators mit dem Folienverbund verbunden ist und ein zweiter elektrischer Anschluss des Kondensators mit der strukturierten Leitungsschicht des Substrats elektrisch leitend verbunden ist, wobei der Kollektor des ersten Halbleiterschalters mit der Kathode der ersten Diode und mit dem zweiten elektrischen Anschluss des Kondensators elektrisch leitend verbunden ist und der Emitter des ersten Halbleiterschalters mit dem Kollektor des zweiten Halbleiterschalters und mit der Anode der ersten Diode und mit der Kathode der zweiten Diode elektrisch leitend verbunden ist, und der Emitter des zweiten Halbleiterschalters mit der Anode der zweiten Diode und mit dem ersten elektrischen Anschluss des Kondensators elektrisch leitend verbunden.

Vorteilhafte Ausbildungen der Erfindung ergeben sich aus den abhängigen Ansprüchen.

Es erweist sich als vorteilhaft, wenn der zweite elektrische Anschluss des Kondensators mit der strukturierten Leitungsschicht des Substrats elektrisch leitend verbunden ist, indem der zweite Abschluss des Kondensators mit der strukturierten Leitungsschicht verbunden ist. Hierdurch wird ein besonders kompakter Aufbau des Halbleitermoduls ermöglicht.

Weiterhin erweist es sich als vorteilhaft, wenn der zweite elektrische Anschluss des Kondensators mit der strukturierten Leitungsschicht des Substrats elektrisch leitend verbunden ist, indem der zweite elektrische Anschluss des Kondensators mit der zweiten metallischen Folienschicht verbunden ist und die zweite metallische Folienschicht mit der strukturierten Leitungsschicht verbunden ist, wobei der Kondensator zwischen der ersten und der zweiten metallischen Folienschicht angeordnet ist, da hierdurch eine variable Anordnung des Kondensators und ein flexibler Aufbau des Halbleitermoduls ermöglicht wird.

Ferner erweist sich als vorteilhaft, wenn die zweite Diode und der erste Halbleiterschalter auf der strukturierten Leitungsschicht entlang einer ersten Linie angeordnet sind und der zweite Halbleiterschalter und die erste Diode auf der strukturierten Leitungsschicht entlang einer zweiten Linie angeordnet sind, wobei die erste Linie parallel oder in einem Wickel (α) zur zweiten Linie verläuft, wobei der erste und der zweite Halbleiterschalter auf der strukturierten Leitungsschicht zueinander diagonal angeordnet sind, wobei die erste und die zweite Diode auf der strukturierten Leitungsschicht zueinander diagonal angeordnet sind. Hierdurch wird ein besonders niederinduktiver Aufbau des Halbleitermoduls realisiert.

Weiterhin erweist es sich als vorteilhaft, wenn der Kondensator entlang der ersten Linie angeordnet ist, da durch diese Anordnung des Kondensators ein besonders niederinduktiver Aufbau des Halbleitermoduls realisiert wird.

Weiterhin erweist es sich als vorteilhaft, wenn der Kondensator einen in den Kondensator integrierten elektrischen Widerstand aufweist, da durch den elektrischen Widerstand Überspannungsschwingen schnell abgebaut werden können.

Weiterhin erweist es sich als vorteilhaft, wenn der Kondensator eine Kapazität in einem Bereich von 1nF bis 1000nF oder in einem Bereich von 0,1 mF bis 100 mF aufweist. Wenn der Kondensator als Snubberkondensator dient, weist der Kondensator vorzugsweise eine Kapazität in einem Bereich von 1 nF bis 1000nF auf. Wenn der Kondensator als Zwischenkreiskondensator dient, weist der Kondensator vorzugsweise eine Kapazität in einem Bereich von 0,1 mF bis 100 mF auf.

Ferner erweist sich als vorteilhaft, wenn der Kondensator in Form eines Halbleiterkondensators vorliegt, da dann ein besonders niederinduktiver Aufbau des Halbleitermoduls realisiert wird. Selbstverständlich kann der Kondensator aber auch Form eines anderen Kondensatortyps, wie z.B. in Form eines Folien- oder Keramikkondensators vorliegen.

Weiterhin erweist es sich als vorteilhaft, wenn der zweite Halbleiterschalter und die erste Diode mit dem Folienverbund verbunden sind, da hierdurch ein sehr niederinduktiver Aufbau des Halbleitermoduls realisiert wird.

Ferner erweist es sich als vorteilhaft, wenn das Halbleitermodul einen weiteren Kondensator aufweist, wobei ein erster elektrischer Anschluss des weiteren Kondensators mit dem Folienverbund verbunden ist und ein zweiter elektrischer Anschluss des weiteren Kondensators mit der strukturierten Leitungsschicht des Substrats elektrisch leitend verbunden ist. Hierdurch wird ein besonders kompakter Aufbau des Halbleitermoduls ermöglicht.

Weiterhin erweist es sich als vorteilhaft, wenn der zweite elektrische Anschluss des weiteren Kondensators mit der strukturierten Leitungsschicht des Substrats elektrisch leitend verbunden ist, indem der zweite Abschluss des weiteren Kondensators mit der strukturierten Leitungsschicht verbunden ist. Hierdurch wird ein besonders kompakter Aufbau des Halbleitermoduls ermöglicht.

Weiterhin erweist es sich als vorteilhaft, wenn der zweite elektrische Anschluss des weiteren Kondensators mit der strukturierten Leitungsschicht des Substrats elektrisch leitend verbunden ist, indem der zweite elektrische Anschluss des weiteren Kondensators mit der zweiten metallischen Folienschicht verbunden ist und die zweite metallische Folienschicht mit der strukturierten Leitungsschicht verbunden ist, wobei der weitere Kondensator zwischen der ersten und der zweiten metallischen Folienschicht angeordnet ist, da hierdurch eine variable Anordnung des weiteren Kondensators ermöglicht wird.

Ferner erweist es sich als vorteilhaft, wenn die zweite Diode und der erste Halbleiterschalter auf der strukturierten Leitungsschicht entlang einer ersten Linie angeordnet sind und der zweite Halbleiterschalter und die erste Diode auf der strukturierten Leitungsschicht entlang einer zweiten Linie angeordnet sind, wobei die erste Linie parallel oder in einem Wickel (α) zur zweiten Linie verläuft, wobei der erste und der zweite Halbleiterschalter auf der strukturierten Leitungsschicht zueinander diagonal angeordnet sind, wobei die erste und die zweite Diode auf der Leitungsschicht zueinander diagonal angeordnet sind, wobei der weitere Kondensator entlang der zweiten Linie angeordnet ist. Hierdurch wird ein besonders niederinduktiver Aufbau des Halbleitermoduls realisiert.

Weiterhin erweist es sich als vorteilhaft, wenn der weitere Kondensator einen in den weiteren Kondensator integrierten elektrischen Widerstand aufweist, da durch den elektrischen Widerstand Überspannungsschwingen schnell abgebaut werden können.

Weiterhin erweist es sich als vorteilhaft, wenn der weitere Kondensator eine Kapazität in einem Bereich von 1 nF bis 1000nF oder in einem Bereich von 0,1 mF bis 100 mF aufweist. Wenn der weitere Kondensator als Snubberkondensator dient, weist der weitere Kondensator vorzugsweise eine Kapazität in einem Bereich von 1 nF bis 1000nF auf. Wenn der weitere Kondensator als Zwischenkreiskondensator dient, weist der weitere Kondensator vorzugsweise eine Kapazität in einem Bereich von 0,1 mF bis 100 mF auf.

Ferner erweist es sich als vorteilhaft, wenn der weitere Kondensator in Form eines Halbleiterkondensators vorliegt, da dann ein besonders niederinduktiver Aufbau des Halbleitermoduls realisiert wird.

Ausführungsbeispiele der Erfindung sind in Figuren dargestellt und werden im Folgenden näher erläutert. Dabei zeigen:
FIG 1 ein elektrisches Schaltbild eines erfindungsgemäßen Halbleitermoduls und der durch das Halbleitermodul fließenden Ströme wenn der erste Halbleiterschalter eingeschaltet ist,
FIG 2 ein elektrisches Schaltbild eines erfindungsgemäßen Halbleitermoduls und der durch das Halbleitermodul fließenden Ströme wenn der erste Halbleiterschalter gerade ausgeschaltet worden ist und der Strom durch die zweite Diode fließt,
FIG 3 eine entlang einer ersten Linie des Halbleitermoduls verlaufende schematisierte Schnittdarstellung des erfindungsgemäßen Halbleitermoduls inklusive einer Darstellung des durch das Halbleitermodul fließenden Stromverlaufs wenn der erste Halbleiterschalter eingeschaltet ist,
FIG4 eine schematisierte Ansicht von oben auf das erfindungsgemäßen Halbleitermodul inklusive einer Darstellung des durch das Halbleitermodul fließenden Stromverlaufs wenn der erste Halbleiterschalter eingeschaltet ist,
FIG 5 eine entlang einer ersten Linie des Halbleitermoduls verlaufende schematisierte Schnittdarstellung des erfindungsgemäßen Halbleitermoduls inklusive einer Darstellung des durch das Halbleitermodul fließenden Stromverlaufs wenn der erste Halbleiterschalter gerade ausgeschaltet worden ist und der Strom durch die zweite Diode fließt,
FIG 6 eine schematisierte Ansicht von oben auf das erfindungsgemäßen Halbleitermodul inklusive einer Darstellung des durch das Halbleitermodul fließenden Stromverlaufs wenn der erste Halbleiterschalter gerade ausgeschaltet worden ist und der Strom durch die zweite Diode fließt,
FIG 7 eine weitere Ausbildung des erfindungsgemäßen Halbleitermoduls,
FIG 8 eine weitere Ausbildung des erfindungsgemäßen Halbleitermoduls,
FIG 9 eine entlang einer zweiten Linie des Halbleitermoduls verlaufende schematisierte Schnittdarstellung des erfindungsgemäßen Halbleitermoduls und
FIG 10 eine weitere Ausbildung des erfindungsgemäßen Halbleitermoduls.

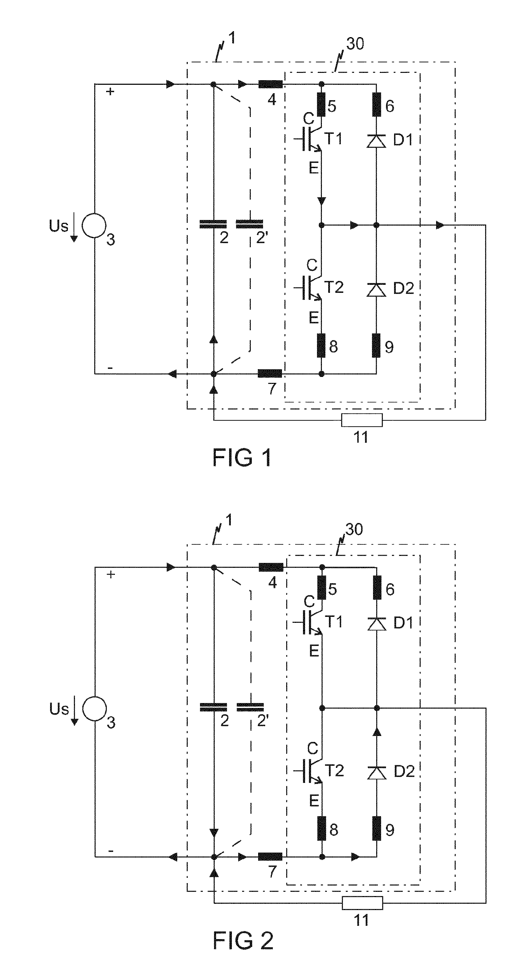

In FIG 1 ist ein elektrisches Schaltbild eines erfindungsgemäßen Halbleitermoduls 1 und die durch das Halbleitermodul 1 fließenden Ströme, wenn der erste Halbleiterschalter T1 eingeschaltet ist, dargestellt. Der Stromverlauf ist dabei in FIG 1 in Form von Pfeilen dargestellt. Das erfindungsgemäße Halbleitermodul 1 weist einen ersten Halbleiterschalter T1, einen zweiten Halbleiterschalter T2, eine erste Diode D1 und eine zweite Diode D2 auf. Der erste Halbleiterschalter T1, der zweite Halbleiterschalter T2, die erste Diode D1 und die zweite Diode D2 sind dabei elektrisch zu einer sogenannten Halbbrückenschaltung 30 verschalten, d.h. der Kollektor C des ersten Halbleiterschalters T1 ist mit der Kathode der ersten Diode D1 elektrisch leitend verbunden und der Emitter E des ersten Halbleiterschalters T1 ist mit dem Kollektor C des zweiten Halbleiterschalters T2 und mit der Anode der ersten Diode D1 und mit der Kathode der zweiten Diode D2 elektrisch leitend verbunden und der Emitter E des zweiten Halbleiterschalters T2 ist mit der Anode der zweiten Diode D2 elektrisch leitend verbunden.

Weiterhin weist das Halbleitermodul 1 einen Kondensator 2 auf, der einen ersten und einen zweiten elektrischen Anschluss aufweist. Der zweite elektrische Anschluss des Kondensators 2 ist mit dem Kollektor C des ersten Halbleiterschalters T1 und mit der Kathode der ersten Diode D1 elektrisch leitend verbunden. Der erste elektrische Anschluss des Kondensators 2 ist mit dem Emitter E des zweiten Halbleiterschalters T2 und mit der Anode der zweiten Diode D2 elektrisch leitend verbunden.

Es sei an dieser Stelle angemerkt, dass das Halbleitermodul 1 zusätzlich zur dargestellten Halbbrückenschaltung 30, noch weitere Halbbrückenschaltungen aufweisen kann, die vorzugsweise in identischer Weise wie die Halbbrückenschaltung 30 mit dem Kondensator 2 verbunden sind. So kann das Halbleitermodul 1 z.B. drei Halbbrückenschaltungen aufweisen mittels derer, durch entsprechende Ansteuerung der Halbleiterschalter der Brückenschaltungen, aus der Gleichspannung Us eine 3-phasige Wechselspannung, z.B. zur Ansteuerung eines Motors, erzeugt wird.

Der Kondensator 2 ist im Rahmen des Ausführungsbeispiels mit einer Gleichspannungserzeugungseinrichtung 3 elektrisch leitend verbunden, die eine Gleichspannung Us erzeugt. Die Brückenschaltung 30 ist mit einer Last 11 elektrisch leitend verbunden. Beim dargestellten Ausführungsbeispiel ist die Gleichspannungserzeugungseinrichtung 3 von extern an das Halbleitermodul 1 angeschlossen. Dies muss nicht notwendiger Weise so sein. Das Halbleitermodul 1 kann auch die Gleichspannungserzeugungseinrichtung 3 aufweisen und die Gleichspannungserzeugungseinrichtung 3 somit integraler Bestandteil des Halbleitermodul 1 sein.

Die elektrischen Verbindungen zwischen den Dioden, Halbleiterschaltern und dem Kondensator 2 weisen parasitäre Induktivitäten 4, 5, 6, 7, 8 und 9 auf, die beim Ausschalten der Halbleiterschalter zu Überspannungen führen. Der Kondensator 2 dient der Reduzierung der Überspannungen und wird fachspezifisch auch als sogenannter Snubberkondensator bezeichnet.

Wenn der erste Halbleiterschalter T1 eingeschaltet ist, fließt der Strom durch den ersten Halbleiterschalter T1 und durch die Last 11.

Wenn der erste Halbleiterschalter T1 ausgeschaltet wird, fließt der Strom infolge der Induktiviät der Last 11 weiter in derselben Richtung durch die Last 11 und kommutiert von dem ersten Halbleiterschalter T1 auf die zweite Diode D2. Der Strom fließt dann durch die zweite Diode D2. Dieser Zustand ist in FIG 2 dargestellt. Der Kommutierungsvorgang des Stroms von dem zweiten Halbleiterschalter T2 auf die erste Diode D1 läuft in analoger Form ab.

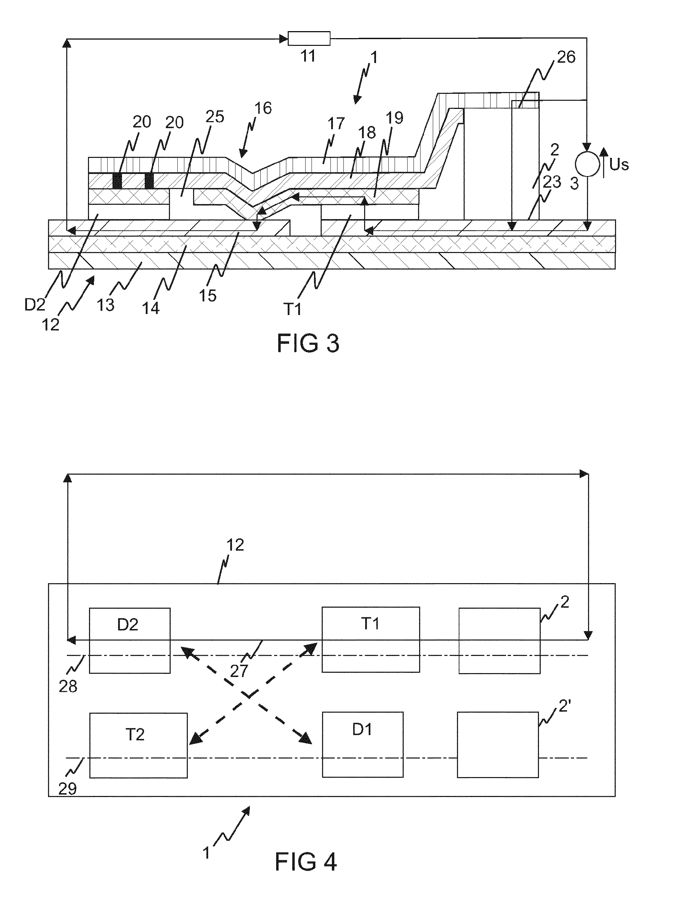

In FIG 3 ist eine schematisierte Schnittdarstellung des erfindungsgemäßen Halbleitermoduls 1, inklusive mittels Pfeilen der durch das Halbleitermodul fließende Stromverlauf, wenn der erste Halbleiterschalter T1 eingeschaltet ist, dargestellt. In FIG 3 sind dabei gleiche Elemente mit den gleichen Bezugszeichen versehen wie in FIG 1 und FIG 2. Der dargestellte Schnitt verläuft dabei entlang der in FIG 4 dargestellten ersten Linie 28.

Das erfindungsgemäße Halbleitermodul 1 weist ein Substrat 12 auf. Das Substrat 12 weist im Rahmen des Ausführungsbeispiels einen elektrisch nicht leitenden Isolierstoffkörper 14 und eine auf dem Isolierstoffkörper 14 angeordnete elektrisch leitende strukturierte Leitungsschicht 15 auf, die infolge ihrer Struktur elektrische Leiterbahnen ausbildet. Vorzugsweise weist das Substrat 12 eine weitere elektrisch leitende vorzugsweise unstrukturierte Leitungsschicht 13 auf, wobei der Isolierstoffkörper 14 zwischen der strukturierten Leitungsschicht 15 und der weiteren Leitungsschicht 13 angeordnet ist. An der weiteren Leitungsschicht 13 ist im Allgemeinen ein Kühlkörper, der zur Kühlung der auf dem Substrat angeordneten Elemente dient, angeordnet. Die strukturierte Leitungsschicht 15 und die weitere Leitungsschicht 13 können z.B. aus Kupfer bestehen. Das Substrat 12 kann z.B. in Form eines DCB-Substrats oder in Form eines Insulated Metal Substrats vorliegen.

Der erste und der zweite Halbleiterschalter T1 und T2 und die erste und die zweite Diode D1 und D2 sind auf der strukturierten Leitungsschicht 15 angeordnet und mit der strukturierten Leitungsschicht 15 verbunden. Die jeweilige Verbindung der Halbleiterschalter und der Dioden mit der strukturierten Leitungsschicht 15 kann dabei z.B. in Form einer Löt- oder einer Sinterverbindung vorliegen. Der erste und der zweite Halbleiterschalter T1 und T2 und die erste und die zweite Diode D1 und D2 sind somit mit der strukturierten Leitungsschicht 15 direkt verbunden. Die Halbleiterschalter und die Dioden sind dabei an ihrer der strukturierten Leitungsschicht 15 zugewandten Seite mit der strukturierten Leitungsschicht 15 verbunden.

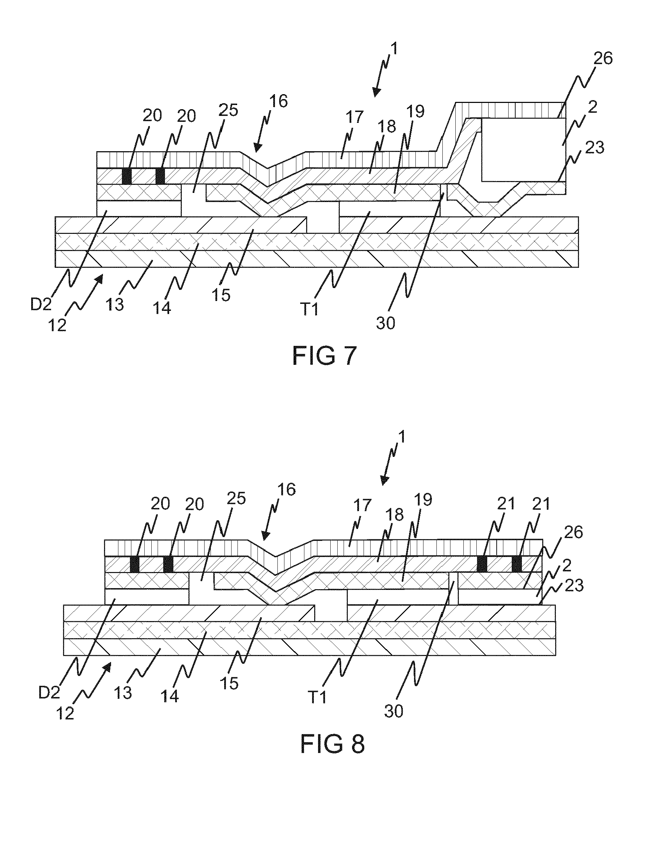

Weiterhin weist das Halbleitermodul 1 einen Folienverbund 16, der eine erste metallische Folienschicht 17 und eine zweite metallische Folienschicht 19, sowie eine zwischen der ersten und eine zweiten metallischen Folienschicht angeordnete elektrisch isolierende Folienschicht 18 aufweist, wobei mindestens eine der metallischen Folienschichten strukturiert ist. Die isolierende Folienschicht 18 kann dabei ebenfalls strukturiert sein, d.h. der Folienverbund 16 kann zumindest einen Bereich aufweisen in dem zwischen der ersten und eine zweiten metallischen Folienschicht keine elektrisch isolierende Folienschicht 18 angeordnet ist. Die isolierende Folienschicht 18 braucht somit nicht über die gesamte Fläche des Folienverbunds 16 zwischen der ersten und der zweiten metallischen Folienschicht angeordnet sein. Die Folienschichten sind vorzugsweise mittels einer Klebeverbindung miteinander verbunden. Die metallischen Folienschichten sind elektrisch leitend und können z.B. aus Aluminium oder Kupfer bestehen. Im Rahmen des Ausführungsbeispiels ist dabei die zweite metallische Folienschicht 19 strukturiert ausgebildet und weist solchermaßen im Rahmen des Ausführungsbeispiels Unterbrechungen 25 und 30 (siehe FIG 7 und FIG 8) auf.

Der erste Halbleiterschalter T1 und die zweite Diode D2 sind mit dem Folienverbund 16 verbunden, wobei die der strukturierten Leitungsschicht 15 abgewandte Seite des ersten Halbleiterschalters T1 und der zweiten Diode D2 im Rahmen des Ausführungsbeispiels mit der zweite metallische Folienschicht 19 verbunden ist. Die Verbindung des ersten Halbleiterschalters T1 und der zweiten Diode D2 mit der zweiten metallischen Folienschicht 19 kann dabei z.B. in Form einer Löt- oder Sinterverbindung vorliegen. Der erste Halbleiterschalter T1 und die zweite Diode D2 sind somit mit dem Folienverbund 16 direkt verbunden.

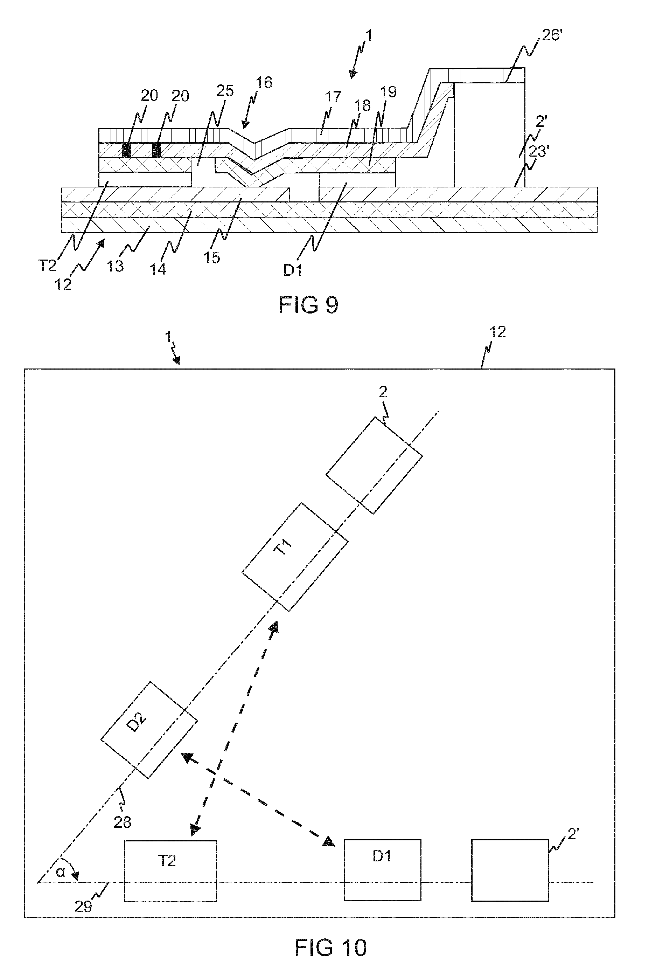

Im Rahmen des Ausführungsbeispiels sind auch, wie in FIG 9 dargestellt, der zweite Halbleiterschalter T2 und die erste Diode D1 mit dem Folienverbund 16 verbunden, wobei die der strukturierten Leitungsschicht 15 abgewandte Seite des zweiten Halbleiterschalters T2 und der ersten Diode D1 im Rahmen des Ausführungsbeispiels mit der zweiten metallischen Folienschicht 19 verbunden ist. Die Verbindung des zweiten Halbleiterschalters T2 und der ersten Diode D1 mit der zweiten metallischen Folienschicht 19 kann dabei ebenfalls z.B. in Form einer Löt- oder Sinterverbindung vorliegen. Der zweite Halbleiterschalter T2 und die erste Diode D1 sind somit mit dem Folienverbund 16 direkt verbunden.

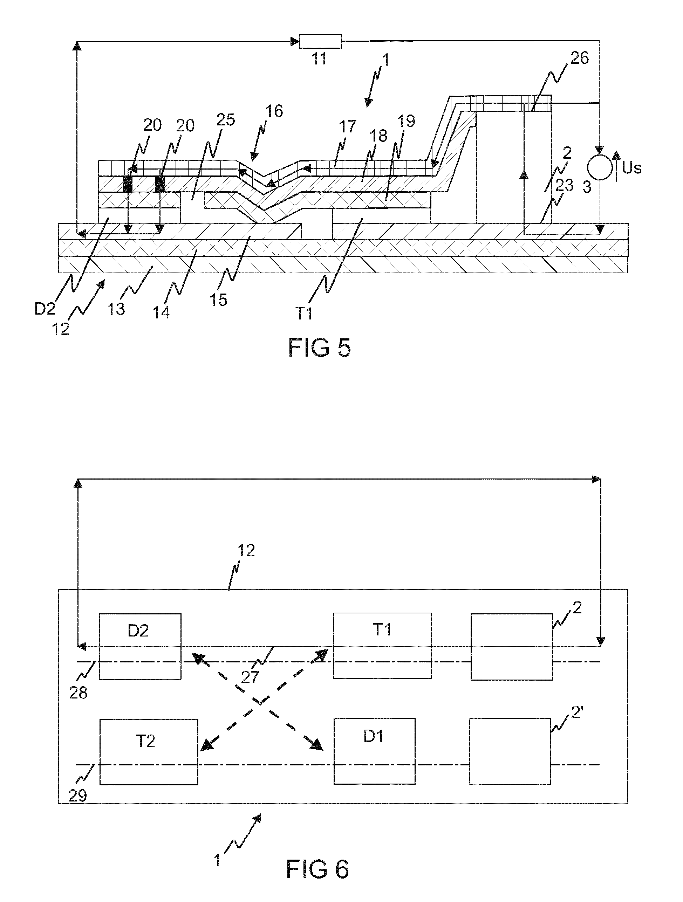

Weiterhin weist das Halbleitermodul 1, wie schon oben beschrieben, einen Kondensator 2 auf, wobei ein erster elektrischer Anschluss 26 des Kondensators 2 ist mit dem Folienverbund 16 verbunden ist und ein zweiter elektrischer Anschluss 23 des Kondensators 2 mit der strukturierten Leitungsschicht 15 des Substrats 12 elektrisch leitend verbunden ist. Bei dem im FIG 3 und FIG 5 beschriebenen Ausführungsbeispiel und bei dem in FIG 8 beschriebenen Ausführungsbeispiel ist der zweite elektrische Anschluss 23 des Kondensators 2 mit der strukturierten Leitungsschicht 15 des Substrats 12 elektrisch leitend verbunden, indem der zweite elektrische Anschluss 23 des Kondensators 2 mit der strukturierten Leitungsschicht 15 verbunden ist. Der Kondensator 2 ist auf der strukturierten Leitungsschicht 15 des Substrats 12 angeordnet. Die Verbindung zwischen dem zweiten elektrischen Anschluss 23 des Kondensators 2 und strukturierten Leitungsschicht 15 kann z.B. in Form einer Löt- oder Sinterverbindung vorliegen. Der zweite elektrische Anschluss 23 des Kondensators 2 ist somit mit der strukturierten Leitungsschicht 15 direkt verbunden.

Der erste elektrische Anschluss 26 des Kondensators 2 ist dabei mit dem Folienverbund 16 verbunden, indem der erste elektrische Anschluss 26 des Kondensators 2 mit der ersten metallischen Folienschicht 17 verbunden ist. Die Verbindung zwischen dem ersten elektrischen Anschluss des Kondensators 2 und der ersten metallischen Folienschicht 17 kann z.B. in Form einer Löt- oder Sinterverbindung vorliegen. Der erste elektrische Anschluss 26 des Kondensators 2 ist somit mit dem Folienverbund 16 direkt verbunden.

Die Folienverbund 16 weist im Rahmen des Ausführungsbeispiels durch die isolierende Folienschicht 18 verlaufende Durchkontaktierungen 20 auf, die im Bereich der Durchkontaktierungen 20 die erste und die zweite metallische Folienschicht 17 und 19 elektrisch leitend miteinander verbinden. Die Durchkontaktierungen 20 bestehen aus einem elektrisch leitfähigen Material.

Durch die erfindungsgemäße elektrische Verbindung des Kondensators 2 mit dem ersten Halbleiterschalter T1 und der zweiten Diode D2 mittels des Folienverbunds 16 und dem Substrat 12 wird eine niederinduktive elektrische Anbindung des Kondensators 2 an die Brückenschaltung 30, sowie ein niederinduktiver Aufbau der Brückenschaltung 30 realisiert.

In FIG 4 ist eine schematisierte Ansicht von oben auf das erfindungsgemäße Halbleitermodul 1 und der durch das Halbleitermodul 1 fließende Stromverlauf mittels Pfeilen, wenn der erste Halbleiterschalter T1 eingeschaltet ist, dargestellt. Dabei ist in FIG 4 der Übersichtlichkeit halber der Folienverbund 16 nicht dargestellt. In FIG 4 sind dabei gleiche Elemente mit den gleichen Bezugszeichen versehen wie in FIG 3. In FIG 3 und FIG 4 ist der zu FIG 1 zugehörige Stromverlauf durch das Halbleitermodul 1 mittels Pfeilen dargestellt.

Die zweite Diode D2 und der erste Halbleiterschalter T1 sind im Rahmen des Ausführungsbeispiels auf der strukturierten Leitungsschicht 15 entlang und insbesondere auf einer ersten Linie 28 angeordnet und der zweite Halbleiterschalter T2 und die erste Diode D1 sind auf der strukturierten Leitungsschicht 15 entlang und insbesondere auf einer zweiten Linie 29 angeordnet, wobei die erste Linie 28 parallel zur zweiten Linie 29 verläuft, wobei der erste und der zweite Halbleiterschalter auf der strukturierten Leitungsschicht 15 zueinander diagonal angeordnet sind, wobei die erste und die zweite Diode auf der strukturierten Leitungsschicht 15 zueinander diagonal angeordnet sind (siehe gestrichelte Pfeile in FIG 4). Die erste und die zweite Linie 28 und 29 sind zueinander beabstandet angeordnet. Der erste Halbleiterschalter T1, der zweite Halbleiterschalter T2, die erste Diode D1 und die zweite Diode D2 sind, wie in FIG 4 dargestellt, im Rahmen des Ausführungsbeispiels rechteckförmig zueinander angeordnet.

FIG 5 entspricht vom physikalischen Aufbau des Halbleitermoduls FIG 3. FIG 6 entspricht vom physikalischen Aufbau des Halbleitermoduls FIG 4, so dass in FIG 5 und FIG 6 gleiche Elemente mit den gleichen Bezugszeichen versehen sind wie in FIG 3 und FIG 4. Während FIG 3 und FIG 4 den Stromverlauf durch das Halbleitermodul 1, wenn der erste Halbleiterschalter T1 eingeschaltet ist, zeigen, ist in FIG 5 und FIG 6 der durch das Halbleitermodul 1 fließende Stromverlauf, wenn der erste Halbleiterschalter T1 gerade ausgeschaltet worden ist und der Strom durch die zweite Diode D2 fließt, dargestellt. In FIG 5 und FIG 6 ist der zu FIG 2 zugehörige Stromverlauf durch das Halbleitermodul 1 mittels Pfeilen dargestellt.

Wie aus FIG 5 und FIG 6 ersichtlich fließt der Strom, infolge der oben beschriebenen vorteilhaften Anordnung des ersten Halbleiterschalters T1, des zweiten Halbleiterschalters T2, der ersten Diode D1 und der erste Diode D2, beim Kommutieren des Stroms von dem ersten Halbleiterschalter T1 auf die Diode D2, stets entlang der ersten Line 28 und stets in die gleiche Richtung, durch das Halbleitermodul, so dass die beim Kommutieren des Stroms wirksamen parasitären Induktivitäten der Verbindungen zwischen den Elementen minimiert werden.

Im Rahmen des Ausführungsbeispiels ist dabei der Kondensator 2 entlang und insbesondere auf der ersten Linie 28 angeordnet, wodurch die wirksamen parasitären Induktivitäten weiter verringert werden. Der Kondensator 2 ist dabei vorzugsweise neben einer aus dem ersten Halbleiterschalter T1 und der zweiten Diode D2 gebildeten ersten Einheit angeordnet.

In FIG 7 ist eine weitere Ausbildung des erfindungsgemäßen Halbleitermoduls 1 dargestellt. Der Aufbau des Halbleitermoduls 1 entspricht dem in FIG 3 dargestellten Aufbau, wobei im Unterschied zu der in FIG 3 dargestellten Ausbildung bei der in FIG 7 dargestellten Ausbildung, der zweite elektrische Anschluss 23 des Kondensators 2 mit der strukturierten Leitungsschicht 15 des Substrats 12 elektrisch leitend verbunden ist, indem der zweite elektrische Anschluss 23 des Kondensators 2 mit der zweiten metallischen Folienschicht 19 verbunden ist und die zweite metallische Folienschicht 19 mit der strukturierten Leitungsschicht 15 verbunden ist, wobei der Kondensator 2 zwischen der ersten und der zweiten metallischen Folienschicht angeordnet ist. Die Verbindungen können z.B. in Form von Löt- oder Sinterverbindungen vorliegen. Der zweite elektrische Anschluss 23 des Kondensators 2 ist somit in diesem Fall mit der zweiten metallischen Folienschicht 19 direkt verbunden und die zweite metallische Folienschicht 19 ist mit der strukturierten Leitungsschicht 15 direkt verbunden. Hierdurch wird ein besonders flexibler Aufbau des Halbleitermoduls ermöglicht. In FIG 7 sind gleiche Elemente mit den gleichen Bezugszeichen versehen wie in FIG 3. Der Kondensator 2 ist dabei im Rahmen des Ausführungsbeispiels über dem Substrat 12 angeordnet.

In FIG 8 ist eine weitere Ausbildung des erfindungsgemäßen Halbleitermoduls 1 dargestellt. Der Aufbau des Halbleitermoduls 1 entspricht im Wesentlichen dem in FIG 3 dargestellten Aufbau, wobei bei der in FIG 8 dargestellten Ausbildung der Kondensator 2 in Form eines Halbleiterkondensators vorliegt. Halbleiterkondensatoren sind z.B. aus der Offenlegungsschrift DE 10 2009 001 919 A1 bekannt und zeichnen sich durch einen besonders flachen Aufbau aus, so dass in Zusammenspiel mit dem Folienverbund 16 ein besonders flacher und damit niederinduktiver Aufbau des Halbleitermoduls 1 realisiert wird. In FIG 8 ist der erste elektrische Anschluss 26 des Kondensators 2 mit dem Folienverbund 16 verbunden, indem der elektrische Anschluss 26 des Kondensators 2 mit der zweiten metallischen Folienschicht 19 verbunden ist. Der Folienverbund 16 weist im Rahmen des Ausführungsbeispiels durch die isolierende Folienschicht 18 verlaufende Durchkontaktierungen 21 auf, die im Bereich der Durchkontaktierungen 21 die erste und die zweite metallische Folienschicht 17 und 19 elektrisch leitend miteinander verbinden. Die Durchkontaktierungen 21 bestehen aus einem elektrisch leitfähigen Material. Es sei an dieser Stelle angemerkt, dass selbstverständlich der in FIG 3 und FIG 4 dargestellte Kondensator 2 alternativ auf die gleiche Weise wie FIG 8 realisiert mit der ersten metallische Folienschicht 17 elektrisch leitend verbunden sein kann.

In FIG 10 ist eine weitere Ausbildung des erfindungsgemäßen Halbleitermoduls 1 dargestellt. Gleiche Elemente sind dabei mit den gleichen Bezugszeichen versehen wie in FIG 4 und FIG 6. Die zweite Diode D2 und der erste Halbleiterschalter T1 sind im Rahmen des Ausführungsbeispiels auf der strukturierten Leitungsschicht 15 entlang und insbesondere auf einer ersten Linie 28 angeordnet und der zweite Halbleiterschalter T2 und die erste Diode D1 sind auf der strukturierten Leitungsschicht 15 entlang und insbesondere auf einer zweiten Linie 29 angeordnet, wobei die erste Linie 28 in einem Wickel α zur zweiten Linie 29 verläuft, wobei der erste und der zweite Halbleiterschalter auf der strukturierten Leitungsschicht 15 zueinander diagonal angeordnet sind, wobei die erste und die zweite Diode auf der strukturierten Leitungsschicht 15 zueinander diagonal angeordnet sind (siehe gestrichelte Pfeile in FIG 10). Im Rahmen des Ausführungsbeispiels ist dabei der Kondensator 2 entlang und insbesondere auf der ersten Linie 28 angeordnet, wodurch die wirksamen parasitären Induktivitäten weiter verringert werden. Der Kondensator 2 ist dabei vorzugsweise neben einer aus dem ersten Halbleiterschalter T1 und der zweiten Diode D2 gebildeten ersten Einheit angeordnet. Durch diese Anordnung der Elemente werden gleiche Weglängen und somit gleiche parasitäre Induktivitäten von dem Wechselstromanschluss des Halbleitermoduls, zu den auf dem Substrat angeordneten Halbleiterschaltern, Dioden und Kondensatoren ermöglicht. Es ergibt sich solchermaßen eine sternförmige Anordnung der Elemente.

In FIG 9 ist eine entlang einer zweiten Linie 29 (siehe FIG 4, FIG 6 und FIG 10) des Halbleitermoduls 1 verlaufende schematisierte Schnittdarstellung des erfindungsgemäßen Halbleitermoduls 1 dargestellt. Gleiche Elemente sind dabei in FIG 9 mit den gleichen Bezugszeichen versehen wir in FIG 3. Im Rahmen des Ausführungsbeispiels weist das Halbleitermodul 1 einen weiteren Kondensator 2' auf, wobei ein erster elektrischer Anschluss 26' des weiteren Kondensators 2' mit dem Folienverbund 16 verbunden ist und ein zweiter elektrischer Anschluss 23' des weiteren Kondensators 2' mit der strukturierten Leitungsschicht 15 des Substrats 12 elektrisch leitend verbunden ist.

Analog zur Darstellung gemäß FIG 7 kann der zweite elektrische Anschluss 23' des weiteren Kondensators 2' mit der strukturierten Leitungsschicht 15 des Substrats 12 elektrisch leitend verbunden sein, indem der zweite elektrische Anschluss 23' des weiteren Kondensators 2' mit der zweiten metallischen Folienschicht 19 verbunden ist und die zweite metallische Folienschicht 19 mit der strukturierten Leitungsschicht 15 verbunden ist, wobei der weitere Kondensator 2' wischen der ersten und der zweiten metallischen Folienschicht angeordnet ist. Analog zur Darstellung gemäß FIG 7 kann der weitere Kondensator 2' dabei über dem Substrat 12 angeordnet sein. Die Verbindungen können z.B. in Form von Löt- oder Sinterverbindungen vorliegen. Der zweite elektrische Anschluss 23' des weiteren Kondensators 2' ist somit mit der zweiten metallischen Folienschicht 19 direkt verbunden und die zweite metallische Folienschicht 19 ist somit mit der strukturierten Leitungsschicht 15 direkt verbunden.

Analog zur Darstellung gemäß FIG 3 kann der zweite elektrische Anschluss 23' des weiteren Kondensators 2' mit der strukturierten Leitungsschicht 15 des Substrats 12 elektrisch leitend verbunden sein, indem der zweite elektrische Abschluss 23' des weiteren Kondensators 2' mit der strukturierten Leitungsschicht 15 verbunden ist. Die Verbindungen können z.B. in Form von Löt- oder Sinterverbindungen vorliegen. Der zweite elektrische Abschluss 23' des weiteren Kondensators 2' ist somit in diesem Fall mit der strukturierten Leitungsschicht 15 direkt verbunden Der weitere Kondensator 2' ist auf der strukturierten Leitungsschicht 15 des Substrats 12 angeordnet..

Im Rahmen des Ausführungsbeispiels ist, wie in FIG 4, FIG 6 und FIG 10 dargestellt, der weitere Kondensator 2' entlang und insbesondere auf der zweiten Linie 29 angeordnet, wodurch die wirksamen parasitären Induktivitäten weiter verringert werden. Dem ersten Halbleiterschalter T1 und der zweiten Diode D2 ist der Kondensator 2 und dem zweiten Halbleiterschalter T2 und der ersten Diode D1 der weitere Kondensator 2' zugeordnet.

In analoger Form wie bei der Kommutierung des Stroms vom ersten Halbleiterschalter T1 auf die zweite Diode D2 fließt der Strom, infolge der oben beschriebenen vorteilhaften Anordnung des ersten Halbleiterschalters T1, des zweiten Halbleiterschalters T2, der ersten Diode D1 und der zweiten Diode D2, beim Kommutieren des Stroms, wenn der zweite Halbleiterschalter T2 ausgeschaltet wird, von dem zweiten Halbleiterschalter T2 auf die erste Diode D1 stets entlang der zweiten Line 29 und stets in die gleiche Richtung, durch das Halbleitermodul, so dass die beim Kommutieren des Stroms wirksamen parasitären Induktivitäten der Verbindungen zwischen den Elementen minimiert werden. Die Stromrichtung ist bei der Kommutierung des Stroms vom zweiten Halbleiterschalter T2 auf die erste Diode D1 entgegengesetzt gegenüber der in FIG 4 und FIG 6 dargestellten Stromrichtung bei der Kommutierung des Stroms vom ersten Halbleiterschalter T1 auf die zweite Diode D2.

Der Kondensator 2 und der weitere Kondensator 2' sind wie in FIG 1 und FIG 2 gestrichelt gezeichnet dargestellt elektrisch parallel geschaltet, wobei der Stromfluss, infolge der in FIG 4, FIG 6 und FIG 10 dargestellten vorteilhaften Anordnung des Kondensators 2 und des weiteren Kondensators 2' im Falle der Kommutierung des Stroms vom ersten Halbleiterschalter T1 auf die Diode D2 im Wesentlichen durch den Kondensator 2 fließt und im Falle der Kommutierung des Stroms vom zweiten Halbleiterschalter T2 auf die Diode D1 im Wesentlichen durch den weiteren Kondensator 2' fließt, wodurch die dabei wirksamen parasitären Induktivitäten minimiert werden.

Selbstverständlich kann auch der weitere Kondensator 2' einen in den weiteren Kondensator 2' integrierten elektrischen Widerstand aufweisen. Weiterhin kann auch der weitere Kondensator 2' in Form eines Halbleiterkondensators vorliegen.

Wie oben beschrieben dient der Kondensator 2 und der weitere Kondensator 2' üblicherweise als sogenannter Snubberkondensator zur Reduzierung von Überspannungen, die bei Kommutierungsvorgängen auftreten. Wenn der Kondensator 2 und/oder der weitere Kondensator 2' als Snubberkondensator dient, weist der jeweilige Kondensator vorzugsweise eine Kapazität in einem Bereich von 1 nF bis 1000nF auf.

Der Kondensator 2 und der weitere Kondensator 2' kann aber auch als sogenannter Zwischenkreiskondensator dienen, der die von der Gleichspannungserzeugungseinrichtung 3 erzeugte elektrische Energie zwischenspeichert und die von der Gleichspannungserzeugungseinrichtung 3 erzeugte elektrische Spannung glättet. Wenn der Kondensator 2 und/oder der weitere Kondensator 2' als Zwischenkreiskondensator dient, weist der jeweilige Kondensator vorzugsweise eine Kapazität in einem Bereich von 0,1 mF bis 100 mF auf.

Es sei an dieser Stelle angemerkt, dass selbstverständlich der weitere Kondensator 2' in der gleichen Weise, wie in den Ausführungsbeispielen zu FIG 7 und zu FIG 8 bezüglich des Kondensators 2 beschrieben, mit dem Folienverbund 16 und mit der strukturierten Leitungsschicht 15 verbunden sein kann.

Im Rahmen des Ausführungsbeispiels ist der Folienverbund 16 einstückig ausgebildet. Der Folienverbund kann jedoch auch mehrstückig und insbesondere zweitstückig ausgebildet sein, wobei z.B. ein erstes Stück des Folienverbunds den ersten Halbleiterschalter T1, die zweite Diode D2 und den Kondensator 2 elektrisch entlang der ersten Linie 28 miteinander verbindet und ein zweites Stück des Folienverbunds den zweiten Halbleiterschalter T2, die erste Diode D1 und den weiteren Kondensator 2' elektrisch entlang der zweiten Linie 29 miteinander verbindet.

Es sei weiterhin an dieser Stelle angemerkt, dass es sich bei den Darstellungen in FIG 3 bis FIG 10 um schematisierte Darstellungen handelt und die gezeigten Elemente nicht maßstabgerecht dargestellt sind.

Ferner sei an dieser Stelle angemerkt, dass elektrisch parallel zu der ersten Diode D1 ein zusätzlicher erster Kondensator und elektrisch parallel zu der zweiten Diode D2 ein zusätzlicher zweiter Kondensator geschaltet sein kann. Der zusätzliche zweite Kondensator kann dabei entlang und insbesondere auf der ersten Linie 28 angeordnet sein und der zusätzliche erste Kondensator kann dabei entlang und insbesondere auf der zweiten Linie 29 angeordnet sein. Der zusätzliche erste und der zusätzliche zweite Kondensator können dabei jeweilig einen in den zusätzlichen ersten und in den zusätzlichen zweiten Kondensator integrierten elektrischen Widerstand aufweisen. Der zusätzliche erste und der zusätzliche zweite Kondensator können insbesondere in Form eines Halbleiterkondensators vorliegen.

Im Rahmen des Ausführungsbeispiels sind der erste und der zweite Halbleiterschalter als IGBT ausgebildet. Selbstverständlich können die Halbleiterschalter aber auch in Form eines anderen Halbleiterschaltertyps, wie z.B. in Form eines MOSFET, vorliegen. Im Sinne der vorliegenden Erfindung, schließt der Begriff Emitter auch den bei einem anderen Halbleiterschaltertyp zum Emitter analogen Anschluss und der Begriff Gate den bei einem anderen Halbleiterschaltertyp zum Gate analogen Anschluss mit ein. Bei einem MOSFET wird z.B. fachspezifisch der bei einem IGBT mit Emitter bezeichnete Anschluss als Source und der bei einem IGBT mit Kollektor bezeichnete Anschluss als Drain bezeichnet. Es sei deshalb an dieser Stelle angemerkt, dass im Sinne der vorliegenden Erfindung, z.B. der Begriff Emitter auch den Begriff Source und der Begriff Kollektor auch den Begriff Drain mit einschließt.

## Patentansprüche

1. Halbleitermodul mit einem Substrat (12) und einem Kondensator (2), wobei das Substrat (12) einen Isolierstoffkörper (14) und eine auf dem Isolierstoffkörper (14) angeordnete elektrisch leitende strukturierte Leitungsschicht (15) aufweist, wobei auf der strukturierten Leitungsschicht (15) ein erster und ein zweiter Halbleiterschalter (T1,T2) und eine erste und eine zweite Diode (D1,D2) angeordnet sind und mit der strukturierten Leitungsschicht (15) verbunden sind, wobei das Halbleitermodul (1) einen Folienverbund (16), der eine erste und eine zweite metallische Folienschicht (17,19) sowie eine zwischen der ersten und eine zweiten metallischen Folienschicht (17,19) angeordnete elektrisch isolierende Folienschicht (18) aufweist, wobei mindestens eine der metallischen Folienschichten (17,19) strukturiert ist, wobei der erste Halbleiterschalter (T1) und die zweite Diode (D2) mit dem Folienverbund (16) verbunden sind, wobei ein erster elektrischer Anschluss (26) eines Kondensators (2) mit dem Folienverbund (16) verbunden ist und ein zweiter elektrischer Anschluss (23) des Kondensators (2) mit der strukturierten Leitungsschicht (15) des Substrats (12) elektrisch leitend verbunden ist, wobei der Kollektor (C) des ersten Halbleiterschalters (T1) mit der Kathode der ersten Diode (D1) und mit dem zweiten elektrischen Anschluss (23) des Kondensators (2) elektrisch leitend verbunden ist und der Emitter (E) des ersten Halbleiterschalters (T1) mit dem Kollektor (C) des zweiten Halbleiterschalters (T2) und mit der Anode der ersten Diode (D1) und mit der Kathode der zweiten Diode (D2) elektrisch leitend verbunden ist, und der Emitter (E) des zweiten Halbleiterschalters (T2) mit der Anode der zweiten Diode (D2) und mit dem ersten elektrischen Anschluss (26) des Kondensators (2) elektrisch leitend verbunden ist.

2. Halbleitermodul nach Anspruch 1, **dadurch gekennzeichnet, dass** der zweite elektrische Anschluss (23) des Kondensators (2) mit der strukturierten Leitungsschicht (15) des Substrats (12) elektrisch leitend verbunden ist, indem der zweite Abschluss (23) des Kondensators (2) mit der strukturierten Leitungsschicht (15) verbunden ist.

3. Halbleitermodul nach Anspruch 1, **dadurch gekennzeichnet, dass** der zweite elektrische Anschluss (23) des Kondensators (2) mit der strukturierten Leitungsschicht (15) des Substrats (12) elektrisch leitend verbunden ist, indem der zweite elektrische Anschluss (23) des Kondensators (2) mit der zweiten metallischen Folienschicht (19) verbunden ist und die zweite metallische Folienschicht (19) mit der strukturierten Leitungsschicht (15) verbunden ist, wobei der Kondensator (2) zwischen der ersten und der zweiten metallischen Folienschicht (17,19) angeordnet ist.

4. Halbleitermodul nach einem der vorhergehenden Ansprüche, **dadurch gekennzeichnet, dass** die zweite Diode (D2) und der erste Halbleiterschalter (T1) auf der strukturierten Leitungsschicht (15) entlang einer ersten Linie (28) angeordnet sind und der zweite Halbleiterschalter (T2) und die erste Diode (D1) auf der strukturierten Leitungsschicht (15) entlang einer zweiten Linie (29) angeordnet sind, wobei die erste Linie (28) parallel oder in einem Wickel (α) zur zweiten Linie (29) verläuft, wobei der erste und der zweite Halbleiterschalter (T1,T2) auf der strukturierten Leitungsschicht (15) zueinander diagonal angeordnet sind, wobei die erste und die zweite Diode (D1,D2) auf der strukturierten Leitungsschicht (15) zueinander diagonal angeordnet sind.

5. Halbleitermodul nach Anspruch 4, **dadurch gekennzeichnet, dass** der Kondensator (2) entlang der ersten Linie (28) angeordnet ist.

6. Halbleitermodul nach einem der vorhergehenden Ansprüche, **dadurch gekennzeichnet, dass** der Kondensator (2) einen in den Kondensator (2) integrierten elektrischen Widerstand aufweist.

7. Halbleitermodul nach einem der vorhergehenden Ansprüche, **dadurch gekennzeichnet, dass** der Kondensator (2) eine Kapazität in einem Bereich von 1 nF bis 1000nF oder in einem Bereich von 0,1 mF bis 100 mF aufweist.

8. Halbleitermodul nach einem der vorhergehenden Ansprüche, **dadurch gekennzeichnet, dass** der Kondensator (2) in Form eines Halbleiterkondensators vorliegt.

9. Halbleitermodul nach einem der vorhergehenden Ansprüche, **dadurch gekennzeichnet, dass** der zweite Halbleiterschalter (T2) und die erste Diode (D1) mit dem Folienverbund (16) verbunden sind.

10. Halbleitermodul nach einem der vorhergehenden Ansprüche, **dadurch gekennzeichnet, dass** das Halbleitermodul (1) einen weiteren Kondensator (2') aufweist, wobei ein erster elektrischer Anschluss (26') des weiteren Kondensators (2') mit dem Folienverbund (16) verbunden ist und ein zweiter elektrischer Anschluss (23') des weiteren Kondensators (2') mit der strukturierten Leitungsschicht (15) des Substrats (12) elektrisch leitend verbunden ist.

11. Halbleitermodul nach Anspruch 10, **dadurch gekennzeichnet, dass** der zweite elektrische Anschluss (23') des weiteren Kondensators (2') mit der strukturierten Leitungsschicht (15) des Substrats (12) elektrisch leitend verbunden ist, indem der zweite Abschluss (23') des weiteren Kondensators (2') mit der strukturierten Leitungsschicht (15) verbunden ist.

12. Halbleitermodul nach Anspruch 10, **dadurch gekennzeichnet, dass** der zweite elektrische Anschluss (23') des weiteren Kondensators (2') mit der strukturierten Leitungsschicht (15) des Substrats (12) elektrisch leitend verbunden ist, indem der zweite elektrische Anschluss (23') des weiteren Kondensators (2') mit der zweiten metallischen Folienschicht (19) verbunden ist und die zweite metallische Folienschicht (19) mit der strukturierten Leitungsschicht (15) verbunden ist, wobei der weitere Kondensator (2') zwischen der ersten und der zweiten metallischen Folienschicht (17,19) angeordnet ist.

13. Halbleitermodul nach einem der Ansprüche 10 bis 12, **dadurch gekennzeichnet, dass** die zweite Diode (D2) und der erste Halbleiterschalter (T1) auf der strukturierten Leitungsschicht (15) entlang einer ersten Linie (28) angeordnet sind und der zweite Halbleiterschalter (T2) und die erste Diode (D1) auf der strukturierten Leitungsschicht (15) entlang einer zweiten Linie (29) angeordnet sind, wobei die erste Linie (28) parallel oder in einem Wickel (α) zur zweiten Linie (29) verläuft, wobei der erste und der zweite Halbleiterschalter (T1,T2) auf der strukturierten Leitungsschicht (15) zueinander diagonal angeordnet sind, wobei die erste und die zweite Diode (D1,D2) auf der strukturierten Leitungsschicht (15) zueinander diagonal angeordnet sind, wobei der weitere Kondensator (2') entlang der zweiten Linie (29) angeordnet ist.

14. Halbleitermodul nach einem Ansprüche 10 bis 13, **dadurch gekennzeichnet, dass** der weitere Kondensator (2') einen in den weiteren Kondensator (2') integrierten elektrischen Widerstand aufweist.

15. Halbleitermodul nach einem der Ansprüche 10 bis 14, **dadurch gekennzeichnet, dass** der weitere Kondensator (2') eine Kapazität in einem Bereich von 1 nF bis 1000nF oder in einem Bereich von 0,1 mF bis 100 mF aufweist.

16. Halbleitermodul nach einem der Ansprüche 10 bis 15, **dadurch gekennzeichnet, dass** der weitere Kondensator (2') in Form eines Halbleiterkondensators vorliegt.
